# EUROPEAN PATENT APPLICATION

(11) **EP 4 644 457 A1**
(43) Date of publication of application: **05.11.2025**
(21) Application number: 23911231.1
(22) Date of filing: 27.07.2023
(51) Int. Cl.: C08G 59/68, C09J 11/06, C09J 163/00, C09J 171/00, C09J 201/00, H01L 21/52

(54) **CURABLE RESIN COMPOSITION, ADHESIVE, SEALING MATERIAL, CURED PRODUCT, SEMICONDUCTOR APPARATUS, AND ELECTRONIC DEVICE**

(30) Priority: 27.12.2022 JP 2022210520
(71) Applicant: Namics Corporation, Niigata-shi, Niigata 950-3131 (JP)
(72) Inventor: SUZUKI, Fumiya, Niigata-shi, Niigata 950-3131 (JP); IWAYA, Kazuki, Niigata-shi, Niigata 950-3131 (JP)
(74) Representative: Mathys & Squire
(86) International application number: PCT/JP2023/027621
(87) International publication number: WO 2024/142447

(57) **Abstract**

Provided are a curable resin composition, an adhesive, and a sealing material which can be cured at a low temperature, from which a cured product having a low Tg is obtained, and have excellent followability to an adherend, the cured product having a low Tg, and a semiconductor device and an electronic device including the cured product. A curable resin composition contains: (A) a cationically curable resin, (B) an acid generator containing an iodonium salt; and (C) a peroxydicarbonate-type organic peroxide, and in the curable resin composition, the component (A) contains at least one selected from the group consisting of: (A1) an epoxy resin having a ring skeleton in a molecule of the epoxy resin; and (A2) an oxetane resin.

## Description

### TECHNICAL FIELD

The present invention relates to a curable resin composition, an adhesive, a sealing material, a cured product, a semiconductor device, and an electronic device.

### BACKGROUND ART

A curable resin composition containing a cationic polymerizable compound is used as an adhesive in the field of electronic devices because a cured product thereof is excellent in characteristics such as adhesiveness, electrical insulation properties, chemical resistance, and mechanical strength.

For example, PATENT LITERATURE 1 describes that in a thermal cationic polymerizable composition that can be used in the field of adhesives and the like, a component that is insufficiently cured volatilizes as outgas in a heat resistance test and the like, and contaminates the surroundings. PATENT LITERATURE 1 discloses a thermal cationic polymerizable composition capable of maintaining a high glass transition temperature (Tg) of more than 100°C by adjusting an amount of a thermal cation initiator added in the composition in order to reduce an amount of the outgas.

### CITATION LIST

### PATENT LITERATURE

PATENT LITERATURE 1: JP-A-2022-105415

### SUMMARY OF INVENTION

### PROBLEMS TO BE SOLVED BY INVENTION

In a case where an adherend to be bonded is a member of a precision instrument such as a camera module or a sensor module, it is required that the adhesive can be cured at a low temperature, and an adhesive from which a cured product having a low Tg is obtained is desired. In addition, in a case where different types of materials are often bonded as in the camera module or the sensor module, in order to alleviate expansion and contraction due to a difference in linear expansion coefficients of different materials, the adhesive may be required to have followability following the expansion and contraction of the adherend.

Therefore, an object of the present invention is to provide a curable resin composition, an adhesive, and a sealing material that can be cured by heating at a low temperature of, for example, 100°C or lower, preferably 80°C or lower, a cured product obtained by curing them and having a low Tg and excellent followability to the adherend, and a semiconductor device and an electronic device including the cured product.

### SOLUTION TO PROBLEMS

Means for solving the above problems are as follows, and the present invention includes the following aspects.
[1] A curable resin composition containing the following components (A) to (C):
   (A) a cationically curable resin;
   (B) an acid generator containing an iodonium salt; and
   (C) a peroxydicarbonate-type organic peroxide.
[2] The curable resin composition according to the above [1], in which the component (A) contains at least one selected from the group consisting of:
   (A1) an epoxy resin having a ring skeleton in a molecule of the epoxy resin; and
   (A2) an oxetane resin.
[3] The curable resin composition according to the above [2], in which the component (A1) has an aromatic ring skeleton.
[4] The curable resin composition according to any one of the above [1] to [3], in which a one-hour half-life temperature of the component (C) is 50°C to 80°C.
[5] The curable resin composition according to any one of the above [1] to [4], in which iodonium salt contained in the component (B) is an iodonium salt compound represented by the following Formula (1):

   **Aᵣ¹**-**I⁺-Aᵣ²·Z⁻** **(1)**

   (in Formula (1), Ar¹ and Ar² are each independently a substituted or unsubstituted aryl group, and Z⁻ is an anion).
[6] The curable resin composition according to the above [5], in which Z⁻ in Formula (1) is BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s may be the same or different from each other).
[7] The curable resin composition according to the above [2] or [3], in which the component (A1) contains an epoxy resin having an epoxy group equivalent of 100 g/eq to 1000 g/eq.
[8] An adhesive or a sealing material containing the curable resin composition according to any one of the above [1] to [7].
[9] A cured product obtained by curing the curable resin composition according to any one of the above [1] to [7], or the adhesive or the sealing material according to the above [8].
[10] The cured product according to the above [9], in which the cured product has a glass transition temperature (Tg) of 0°C to 100°C.
[11] A semiconductor device including the cured product according to the above [9] or [10].
[12] An electronic device including the cured product according to the above [9] or [10].

### EFFECTS OF INVENTION

According to the present invention, it is possible to provide a curable resin composition, an adhesive, and a sealing material that can be cured by heating at a low temperature of 100°C or lower, preferably 80°C or lower, a cured product obtained by curing them and having a low Tg and excellent followability to the adherend, and a semiconductor device and an electronic device including the cured product.

### BRIEF DESCRIPTION OF DRAWINGS

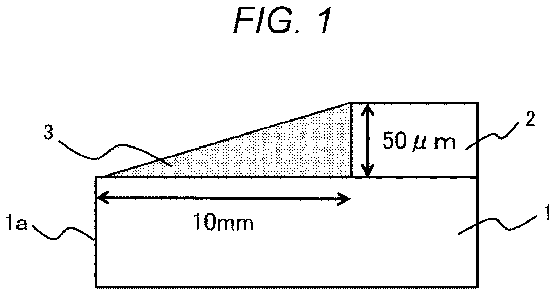

Fig. 1 is a view illustrating a method for producing a test piece for thin-film cured product test.

### DESCRIPTION OF EMBODIMENTS

Hereinafter, a curable resin composition, an adhesive, a sealing material, a cured product obtained by curing them, a semiconductor device and an electronic device including the cured product according to the present disclosure will be described based on embodiments. However, the following embodiments are examples for embodying a technical idea of the present invention, and the present invention is not limited to the following curable resin composition, adhesive, sealing material, cured product, semiconductor device, and electronic device. In the present specification, following the convention in the field of synthetic resins, for a component constituting a curable resin composition before curing, a name including a term "resin" usually indicating a polymer (particularly a synthetic polymer) may be used although the component is not a polymer.

### Resin composition

The cured resin composition according to a first embodiment of the present invention is a curable resin composition containing: (A) a cationically curable resin (hereinafter, also referred to as "component (A)"); (B) an acid generator containing an iodonium salt (hereinafter, also referred to as "component (B)"); and (C) a peroxydicarbonate-type organic peroxide (hereinafter, also referred to as "component (C)").

A curable resin composition from which a cured product is obtained by a radical redox reaction using an iodonium salt-based cationic polymerization initiator and an organic peroxide as a thermal radical polymerization initiator can be cured at a relatively low temperature, and a cured product having substantially the same physical properties is obtained even in a case where the composition is cured by heat or even in a case where the composition is cured by heat and ultraviolet irradiation.

However, radicals generated from the organic peroxide are susceptible to curing inhibition by oxygen. The radicals generated from the organic peroxide undergo a hydrogen abstraction reaction to generate a stable alkyl radical such as a tertiary radical. The stable alkyl radical reacts with oxygen to generate a relatively stable peroxide radical. Since the peroxide radical is stable, it hardly reacts with an iodonium salt-based compound. Therefore, the radical redox reaction is easily inhibited. As the obtained cured product is a thin-film cured product having a smaller thickness, the curing inhibition by oxygen is more likely to occur. This is considered to be because as the thickness of the thin-film cured product is thinner, an area exposed to air relative to a volume of the cured product increases. When the curing inhibition by oxygen is caused, there is a concern that adhesion is insufficient in a portion where curing is insufficient, strength of adhesion is reduced, and deterioration is likely to occur. Adhesion failure due to the curing inhibition by oxygen is observed in both a resin composition from which a cured product having a high Tg is obtained and a resin composition from which a cured product having a low Tg is obtained, but particularly in a case where the Tg is low, the curing inhibition by oxygen is likely to be observed. In the present specification, the cured product having a low Tg refers to a cured product having a Tg of, for example, 120°C or lower, may be a cured product having a Tg of 118°C or lower, and is preferably a cured product having a Tg of 0 to 100°C. In a case where the cured product is in the form of a thin film and is insufficiently cured, outgas may be generated to contaminate the surroundings. On the other hand, in a case where the cured product is in the form of a thin film and is sufficiently cured, the outgas is reduced and contamination of the surroundings can be improved. Examples of the thin-film cured product include a film-like, layer-like, or film-like cured product having a thickness of 100 µm or less.

The curable resin composition contains the peroxydicarbonate-type organic peroxide of the component (C). Carbonate radicals generated from the component (C) react quickly to extract hydrogen from other compounds contained in the curable resin composition, to generate unstable alkyl radicals such as primary radicals. Since the unstable alkyl radicals are prone to radical redox reactions, it is considered that a reaction rate of the unstable alkyl radical is faster than that of the curing inhibition by oxygen. Therefore, it is considered that the carbonate radicals generated from the component (C) can rapidly progress a curing reaction of the cationically curable resin. Furthermore, it is considered that since the carbonate radical is faster in hydrogen abstraction reaction than an alkoxy radical, instantaneous radical concentration in curable resin composition system is higher than that of organic peroxides other than the component (C). Therefore, even if the carbonate radicals generated from the component (C) are affected by the inhibition by oxygen, a large amount of radicals remaining without being inhibited remain and can react with the component (B), and the curing reaction of the cationically curable resin can be rapidly advanced. Even in a case where the curable resin composition produces the thin-film cured product, a polymerization reaction proceeds more quickly than that the curing inhibition by oxygen is caused. Therefore, the curing can be performed by heating at a low temperature of, for example, 100°C or lower, preferably 90°C or lower, more preferably 85°C or lower, and still more preferably 80°C or lower, and the cured product having a low Tg can be obtained. In addition, even in a case where a thin-film cured product having a thickness of 100 µm or less, preferably 0.5 µm or more and 100 µm or less is obtained, the curing inhibition by oxygen is suppressed, and the curable resin composition is cured by heating at a low temperature of, for example, 100°C or lower, preferably 80°C or lower to obtain the cured product having a low Tg. When the thickness of the cured product is 0.5 µm to 100 µm, it is referred to as the thin-film cured product. The thickness of the cured product may be 90 µm or less, 80 µm or less, 70 µm or less, and 1 µm or more.

In a case where the curable resin composition is used as an adhesive for bonding different types of materials such as a camera module and a sensor module, in order to alleviate expansion and contraction due to a difference in linear expansion coefficients of different materials, the adhesive may be required to have followability following expansion and contraction of an adherend. In order to obtain a cured product having followability, it is considered that the curable resin composition contains a resin having a large functional group equivalent as the cationically curable resin. Here, the functional group equivalent refers to a proportion of functional groups that are reactive groups in one molecule. For example, in a case of an epoxy resin, the epoxy group equivalent refers to an epoxy group equivalent which is a molecular weight per equivalent of epoxy groups in the compound. For example, in a case of an oxetane resin, the oxetane group equivalent refers to an oxetane group equivalent which is a molecular weight per equivalent of oxetane groups in the compound. The epoxy group equivalent or the oxetane group equivalent can be measured in accordance with JIS K7236:2001 (corresponding to ISO3001:1999). The number of functional group equivalents such as the number of epoxy group equivalents and the number of oxetane group equivalents represents the number of functional groups (equivalent number) per mass (charged amount) of the compound. The resin or compound having a large functional group equivalent in the curable resin composition has a slower reaction rate than a resin or compound having a small functional group equivalent. Therefore, in a case of containing the resin or compound having a large functional group equivalent as the cationically curable resin, cationic reactivity is not sufficient, and when an insufficient cured portion is formed, the adhesion failure may occur. The curable resin composition containing the resin or compound having a large functional group equivalent provides a cured product having a low storage modulus (E'), a low Tg, and the followability following the expansion and contraction of the adherend.

Since the curable resin composition of the present invention contains (B) the acid generator containing the iodonium salt and (C) the peroxydicarbonate-type organic peroxide, curing failure is less likely to occur even in a case of using the resin having a large functional group equivalent as the cationically curable resin. The peroxydicarbonate-type organic peroxide has a relatively low half-life temperature, and is excellent in reactivity at low temperatures. It is considered that radicals derived from the component (C) have a higher reaction rate between the generated radicals and the component (B) than that of the curing inhibition by oxygen. Therefore, the radical redox reaction is likely to occur, and an acid (a cation: H⁺) can be efficiently generated. For example, even when heating is performed at a low temperature of 100°C or lower, preferably 80°C or lower, the curing reaction of the cationically curable resin rapidly proceeds to suppress partial curing failure, so that the cured product having a low Tg can be obtained.

In order to obtain the cured product having followability, it is considered that the curable resin composition contains, for example, a resin having a linear alkyl group or alkylene group having a large number of carbon atoms as the cationically curable resin. A resin having a linear long-chain alkyl group or alkylene group having a large number of carbon atoms tends to have lower cationic reactivity than a resin having a linear alkyl group or alkylene group having a small number of carbon atoms.

Since the curable resin composition of the present invention contains (B) the acid generator containing the iodonium salt and (C) the peroxydicarbonate-type organic peroxide, the curable resin composition can be cured even in a case of using the resin having a large functional group equivalent as the cationically curable resin. For example, by heating at a low temperature of 100°C or lower, preferably 80°C or lower, even a cationically curable resin having a large functional group equivalent exhibits cationic reactivity, the curing reaction proceeds rapidly, and a cured product having followability can be obtained.

In addition, from a curable resin composition containing a resin having a ring skeleton such as an aromatic ring in the molecule, the cured product having followability following the expansion and contraction of the adherend is obtained. However, the resin having a ring skeleton such as an aromatic ring in the molecule tends to have low cationic reactivity.

Since the curable resin composition of the present invention contains (B) the acid generator containing an iodonium salt and (C) the peroxydicarbonate-type organic peroxide, even in a case where the resin having a ring skeleton in the molecule is used as the cationically curable resin, radicals are efficiently generated from the peroxydicarbonate-type organic peroxide, the radical redox reaction is likely to occur, a cationically curable resin having an aromatic ring in the molecule is quickly cured by heating at a low temperature of, for example, 100°C or lower, preferably 80°C or lower, and a cured product having excellent followability to the adherend can be obtained.

### Component (A): Cationically curable resin

The cationically curable resin of the component (A) refers to a resin having one or more cationically polymerizable groups in the molecule, and examples of the cationically polymerizable groups include an epoxy group, an oxetanyl group, and a vinyl ether group. Examples of the cationically curable resin include epoxy resins, oxetane resins, polystyrene-based compounds, and vinyl ether compounds. The cationically curable resin of the component (A) preferably has a molecular weight of 100 to 800 and may have a molecular weight of 110 to 780, in order to obtain a cured product having a low Tg and excellent followability to the adherend by curing the cationically curable resin of the component (A) by heating at a low temperature of 100°C or lower, preferably 80°C or lower.

The cationically curable resin of the component (A) preferably contains at least one selected from the group consisting of (A1) an epoxy resin having a ring skeleton in a molecule of the epoxy resin (hereinafter, also referred to as "component (A1)") and (A2) an oxetane resin (hereinafter, also referred to as "component (A2)"". When the cured resin composition contains, in the component (A), at least one selected from the group consisting of the epoxy resin having a ring skeleton in the molecule as the component (A1) and the oxetane resin (A2), a cured product having a low Tg, a low elastic modulus, and excellent followability can be obtained. The component (A) may contain the component (A1) alone, or may contain both the component (A1) and the component (A2).

Examples of the epoxy resin include an aliphatic epoxy resin and (A1) the epoxy resin having a ring skeleton in the molecule. The epoxy resin preferably contains (A1) the epoxy resin having a ring skeleton in the molecule. Examples of the ring skeleton include an alicyclic skeleton, an aromatic ring skeleton, a heteroaromatic ring skeleton, and a heterocyclic skeleton. The epoxy resin of the component (A1) preferably contains at least one selected from the group consisting of an epoxy resin having an aromatic ring skeleton in the molecule and an epoxy resin having an alicyclic skeleton in the molecule, and more preferably contains the epoxy resin having an aromatic ring skeleton.

Specific examples of the epoxy resin having an aromatic ring skeleton include, as a polyfunctional epoxy resin, a bisphenol A type epoxy resin (EPICLON (registered trademark) 850, 850-S, EXA-850CRP, EXA-8067, and the like manufactured by DIC Corporation), a special epoxy resin in which a polyalkylene oxide structure is added to a bisphenol A skeleton (AER9000 manufactured by Asahi Kasei Corporation, EP-4000S, EP-4003S, and EP-4010S manufactured by ADEKA Corporation), a bisphenol F type epoxy resin (EPICRON (registered trademark) 830-S, EXA-830LVP, and the like manufactured by DIC Corporation), a bisphenol AD type epoxy resin, a bisphenol S type epoxy resin, a naphthalene type epoxy resin (EPICRON (registered trademark), HP-4032D, HP-720H, and the like manufactured by DIC Corporation), a phenol novolac type epoxy resin (EPICLON (registered trademark) N-740, N-770, and the like manufactured by DIC Corporation), and a cresol volac type epoxy resin (EPICRON (registered trademark), N-660, N-670, N-655-EXP-S, and the like manufactured by DIC Corporation). Specific examples of a polyfunctional epoxy compound contained in the polyfunctional epoxy resin include glycidyl ether of tetra(hydrophenyl)alkane, glycidyl ether of tetrahydroxybenzophenone, and epoxidized polyvinyl phenol. In a monofunctional epoxy resin, examples of a compound contained in the monofunctional epoxy resin include p-tert-butyl phenyl glycidyl ether (ADEKA GLYCILOL (registered trademark), ED-509E, ED-509 S, and the like manufactured by ADEKA Corporation). Note that since the bisphenol A type epoxy resin contains an aromatic ring in the molecule, the bisphenol A type epoxy resin tends to have low reactivity and a high Tg, and thus followability to the adherend may be impaired. Therefore, from the viewpoint of Tg, the bisphenol A type epoxy resin having an epoxy group equivalent of 200 g/eq or less is preferably 20 mass% or less when a total amount of the component (A) is 100 mass%.

The epoxy resin having an alicyclic skeleton only needs to have an alicyclic skeleton in one molecule, and includes a cycloalkylene oxide compound, in which an epoxy group is formed by two carbon atoms and one oxygen atom forming an alicyclic structure. The epoxy resin having an alicyclic skeleton may contain an epoxy compound having an alicyclic skeleton. Examples of the epoxy compound having an alicyclic skeleton include cyclohexane-based, cyclohexyl methyl ester-based, cyclohexyl methyl ether-based, spiro-based, and tricyclodecane-based epoxy compounds. Specific examples of the epoxy resin having an alicyclic skeleton include 3',4'-epoxycyclomethyl-3,4-epoxycyclohexanecarboxylate (CELLOXIDE (registered trademark) 2021P and the like manufactured by Daicel Corporation), (3,3',4,4'-diepoxy)bicyclohexyl (CELLOXIDE (registered trademark) 8010 and the like manufactured by Daicel Corporation), 1,2:8,9-diepoxylimonene, 1,2-epoxy-4-vinylcyclohexane, and 1,2-epoxy-4-(2-oxiranyl)cyclohexane adduct of 2,2-bis(hydroxymethyl)-1-butanol (EHPE3150 and the like manufactured by Daicel Corporation).

Examples of the aliphatic epoxy resin include polyglycidyl ethers of polyhydric alcohols or alkylene oxide adducts thereof. Specific examples of an aliphatic epoxy compound contained in the aliphatic epoxy resin include ethylene glycol diglycidyl ether, diethylene glycol diglycidyl ether, propylene glycol diglycidyl ether, 1,4-butanediol diglycidyl ether, neopentyl glycol diglycidyl ether, 1,6-hexanediol diglycidyl ether, glycerin diglycidyl ether, trimethylolpropane triglycidyl ether (such as Epolite 100MF manufactured by Kyoeisha Chemical Co., Ltd.), and polyethylene glycol diglycidyl ether. Examples of an aliphatic cyclic epoxy resin include hydrogenated bisphenol A diglycidyl ether (such as jER YX8000 manufactured by Mitsubishi Chemical Corporation).

Specific examples of the vinyl ether compound include hydroxybutyl vinyl ether, vinyl ether of 1,4-cyclohexanedimethanol, triethylene glycol divinyl ether, dodecyl vinyl ether, and cyclohexyl vinyl ether.

In a case where the component (A) contains an epoxy resin, the epoxy group equivalent of the epoxy resin is preferably 100 g/eq to 1000 g/eq. In a case where the component (A) contains the epoxy resin having the ring skeleton in the molecule as the component (A1), the component (A1) preferably has an epoxy group equivalent of 100 g/eq to 1000 g/eq. When the epoxy group equivalent of the epoxy resin contained in the component (A) is 100 g/eq to 1000 g/eq, the cured product having a low Tg is obtained in a case of being cured by heating at a low temperature of, for example, 100°C or lower, preferably 80°C or lower. In a case where the component (A) contains an epoxy resin, the epoxy group equivalent of the epoxy resin may be 800 g/eq or less, 600 g/eq or less, 500 g/eq or less, 400 g/eq or less, 120 g/eq or more, 130 g/eq or more, 150 g/eq or more, 180 g/eq or more, or 200 g/eq or more. Note that an epoxy resin having an epoxy group equivalent of 200 g/eq or less has a small number of epoxy group equivalents and tends to have a high Tg, and thus the followability to the adherend may be impaired. Therefore, in a case of containing an epoxy resin having an epoxy group equivalent of 200 g/eq or less, when the total amount of the component (A) is 100 mass%, the epoxy resin having an epoxy group equivalent of 200 g/eq or less is preferably 20 mass% or less, and may be 18 mass% or less, 0 mass%, 1 mass% or more, or 3 mass% or more. From the viewpoint of obtaining the cured product having a low Tg, the epoxy resin having an epoxy group equivalent of more than 200 g/eq is preferably 10 mass% or more, more preferably 20 mass%, still more preferably 30 mass%, and particularly preferably 40 mass% or more when the total amount of the component (A) is 100 mass%. Note that the special epoxy resin in which the polyalkylene oxide structure is added to the bisphenol A skeleton is particularly preferable from the viewpoint of followability to the adherend, and a blending amount thereof is preferably 10 mass% or more and more preferably 20 mass% or more when the total amount of the component (A) is 100 mass%.

The oxetane resin of the component (A2) undergoes a polymerization initiation reaction slower than that of the epoxy resin, but is polymerized at a high speed when concentration of a polymerization initiating species is a certain level or more, and thus the cured product is obtained by a reaction in a short time at a low temperature. Specific examples of the oxetane resin include 3-ethyl-3-hydroxymethyloxetane (oxetane alcohol) (such as OXT-101 manufactured by Toagosei Co., Ltd.), 2-ethylhexyl oxetane (such as OXT-212 manufactured by Toagosei Co., Ltd.), xylylene bisoxetane (such as OXT-121 manufactured by Toagosei Co., Ltd.), 3-ethyl-3-{[(3-ethyloxetane-3-yl)methoxy]methyl}oxetane (such as OXT-221 manufactured by Toagosei Co., Ltd.), oxetanyl silsesquioxetane (such as OXT-191 manufactured by Toagosei Co., Ltd.), phenol novolac oxetane (such as PHOX manufactured by Toagosei Co., Ltd.), and 3-ethyl-3-phenoxymethyloxetane (such as OXT-211 manufactured by Toagosei Co., Ltd.).

In a case where the component (A) contains the oxetane resin of the component (A2), the oxetane group equivalent of the oxetane resin is preferably 100 g/eq to 500 g/eq, and may be 110 g/eq to 300 g/eq. In a case where the oxetane resin of the component (A2) is contained in the component (A), when the oxetane group equivalent of the component (A2) is 100 g/eq to 500 g/eq, the cured product having a low Tg is obtained in a case of being cured by heating at a low temperature of, for example, 100°C or lower, preferably 80°C or lower. In a case where the component (A) contains the oxetane resin of the component (A2), the oxetane group equivalent of the oxetane resin may be 250 g/eq or less.

### Component (B): Acid generator containing iodonium salt

The iodonium salt contained in the acid generator of the component (B) is preferably an iodonium compound represented by the following Formula (1):

**Ar¹-I⁺-Ar²·Z⁻** **(1)**

(in Formula (1), Ar¹ and Ar² are each independently a substituted or unsubstituted aryl group, and Z⁻ is an anion).

The aryl group represents an aromatic hydrocarbon group having 6 to 18 carbon atoms, and examples thereof include a phenyl group, a naphthyl group, and an anthracenyl group. Ar¹ and Ar² in Formula (1) are each independently preferably a phenyl group or a naphthyl group. The aryl group may be unsubstituted or substituted with one or more optional substituents. Examples of the substituent include a linear or branched alkyl group having 1 to 18 carbon atoms, a linear or branched alkoxy group having 1 to 18 carbon atoms, a linear or branched acyloxy group having 2 to 18 carbon atoms, a halogen atom, a cyano group, a nitro group, and a hydroxyl group.

The anion only needs to be a monovalent counter anion, and is preferably a non-antimony-based anion. In Formula (1), the anion represented by Z⁻ is preferably BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s may be the same or different from each other). In Formula (1), nucleophilicity of the anion represented by Z⁻ is preferably relatively low, and when the nucleophilicity of the anion contained in the iodonium salt is low, rate of growth reaction of the cationically curable resin is high, and the cured product can be obtained by heating at a low temperature of, for example, 100°C or lower, preferably 80°C or lower for a short time.

Specific examples of the component (B) include diphenyliodonium hexafluoroarsenate, di(4-chlorophenyl)iodonium hexafluoroarsenate, di(4-bromphenyl)iodonium hexafluoroarsenate, phenyl(4-methoxyphenyl)iodonium hexafluoroarsenate, 4-methylphenyl-4-(1-methylethyl)phenyliodonium hexafluorophosphate, 4-methylphenyl-4-(1-methylethyl)phenyliodonium tri(pentafluoroethyl)trifluorophosphate (for example, IK-1 manufactured by San-Apro Ltd.), 4-methylphenyl-4-(1-methylethyl)phenyliodonium tetrakis(pentafluorophenyl) borate, 4-methylphenyl-4-(2-methylpropyl)phenyliodonium hexafluorophosphate (for example, IRGACURE (registered trademark) 250 manufactured by BASF SE), bis(C₁₀₋₁₄-alkylphenyl)iodonium hexafluorophosphate (for example, WPI-113 manufactured by FUJIFILM Wako Pure Chemical Corporation), 4-methylphenyl-4-(1-methylethyl) phenyliodonium hexafluoroantimonate (for example, WPI-116 and the like manufactured by FUJIFILM Wako Pure Chemical Corporation), IK-1FG (manufactured by San-Apro Ltd.), and 4-isopropyl-4'-methyldiphenyliodonium tetrakis(pentafluorophenyl)borate (for example, Bluesil (registered trademark) PI2074 and the like manufactured by ELKEM SILICONES). As such an iodonium salt, for example, a commercially available product can be used as a cationic initiator or as the iodonium salt contained in the acid generator.

### Component (C): peroxydicarbonate-type organic peroxide

The peroxydicarbonate-type organic peroxide of the component (C) is a radical source. Even if the carbonate radicals generated from the component (C) are affected by the inhibition by oxygen as described above, a large amount of radicals remaining without being inhibited remain and can react with the component (B), so that the curing reaction of the cationically curable resin can be rapidly advanced. Organic peroxides other than peroxydicarbonate type, for example, alkyl peroxy ester type peroxides have lower activity than the peroxydicarbonate-type organic peroxide. Therefore, the reaction rate at which the alkyl radical is generated is slow, and electrons are less likely to move to the acid generator containing the iodonium salt, and thus the iodonium salt is less likely to decompose. As a result, it is considered that the acid (cation: H⁺) is less likely to be generated, and thus the polymerization reaction is less likely to proceed. Note that it is preferable that the curable resin composition does not contain a thermal cationic polymerization initiator. When the curable resin composition contains the component (B) and the component (C), the polymerization reaction can be promoted by heating at a low temperature of 100°C or lower, preferably 80°C or lower, and it is preferable that the curable resin composition does not contain the thermal cationic polymerization initiator in consideration of environmental aspects such as reduction of PFAS (meaning organic fluorine compounds).

The peroxydicarbonate-type organic peroxide of the component (C) has a structure represented by -O-C(=O)-O-O-C(=O)-O-. The peroxydicarbonate-type organic peroxide is a radical source and generates carbonate radicals without decarboxylation reaction. A one-hour half-life temperature of the peroxydicarbonate-type organic peroxide of the component (C) is preferably 50°C to 80°C, may be 55°C to 75°C, and is preferably 55°C to 70°C. When the one-hour half-life temperature of the peroxydicarbonate-type organic peroxide of the component (C) is 50°C to 80°C, even in a case where a thin-film cured product having a thickness of, for example, 100 µm or less is obtained by generating radicals by heating at a low temperature of, for example, 100°C or lower, preferably 80°C or lower, and reductively decomposing the iodonium salt, the curing inhibition by oxygen is suppressed and the polymerization reaction of the cationically curable resin can be promoted. The peroxydicarbonate-type organic peroxide of the component (C) preferably has a molecular weight of 180 to 1000, and may have a molecular weight of 200 to 800 or 220 to 700 or less. When the peroxydicarbonate-type organic peroxide of the component (C) has a molecular weight of 180 to 1000, the polymerization reaction can be carried out by heating at a low temperature of, for example, 100°C or lower, preferably 80°C or lower.

A self-accelerated decomposition temperature (SADT) of the peroxydicarbonate-type organic peroxide of the component (C) is preferably higher than 10°C (> 10°C), more preferably 12°C or higher (≥ 12°C), and still more preferably 15°C or higher (≥ 15°C). The self-accelerated decomposition temperature (SADT) of the peroxydicarbonate-type organic peroxide of the component (C) is preferably 50°C or lower (≤ 50°C), may be 48°C or lower (≤ 48°C), and more preferably 45°C or lower (≤ 45°C). A curable resin composition containing a peroxydicarbonate-type organic peroxide having a SADT of higher than 10°C and 50°C or lower has good storage stability, and the cured product having a low Tg can be obtained by heating at a low temperature of, for example, 100°C or lower, preferably 80°C or lower. The self-accelerated decomposition temperature (SADT) refers to a minimum temperature at which heat generation of 6°C or more or self-accelerated decomposition occurs within 7 days in a certain amount of container, and the self-accelerated decomposition temperature of the organic peroxide refers to a temperature at which the self-accelerated decomposition occurs. As a test method of SADT, there are test methods such as a US SADT test, an adiabatic storage test, an isothermal storage test, and a heat storage test, and a value measured by applying any test method may be used. In a case where a commercially available product described later is used as the peroxydicarbonate-type organic peroxide of the component (C), the SADT may be a catalog value. From the viewpoint of pot life at normal temperature, a state of the component (C) at normal temperature (about 20°C to about 25°C) is preferably solid (powder) rather than liquid.

Examples of the peroxydicarbonate-type organic peroxide of the component (C) include di(secondary butyl) peroxydicarbonate (for example, Lupelox 225 and the like manufactured by ARKEMA Yoshitomi, Ltd.), dicetyl peroxydicarbonate (for example, Perkadox 24L and the like manufactured by Nouryon), di(4-tert-butylcyclohexyl) peroxydicarbonate (for example, PEROYL TCP and the like manufactured by NOF CORPORATION), ditridecyl peroxydicarbonate (manufactured by Alfa Chemistry), and distearyl peroxydicarbonate (manufactured by SAGECHEM LIMITED).

The curable resin composition may contain at least one selected from the group consisting of (D) a photosensitizer, (E) a photoradical generator, and (F) a filler (hereinafter, also respectively referred to as "component (D)", "component (E)", and "component (F)"). The curable resin composition may further contain at least one selected from the group consisting of (G) a coupling agent, (H) an ion trapping agent, and (I) a colorant such as a pigment (hereinafter, also respectively referred to as "component (G)", "component (H)", and "component (I)"). At least one component selected from the group consisting of the coupling agent (G), the ion trapping agent (H), and the colorant (I) may be contained as an optional component.

### (D) Photosensitizer

The photosensitizer is a component for increasing sensitivity of the iodonium salt to light. Examples of the photosensitizer include thioxanthone derivatives, carbonyl compounds, organic sulfur compounds, persulfides, redox-based compounds, azo and diazo compounds, halogen compounds, and photoreducible coloring matter, and the thioxanthone derivatives are preferable. Specific examples of the thioxanthone derivatives include isopropylthioxanthone, 2,4-diethylthioxanthone, 2-chlorothioxanthone, 2,4-diethylthioxanthone, 2-chlorothioxanthone, and thioxanthone ammonium salt, and 2,4-diethylthioxanthone is preferable.

### (E) Photoradical generator

The photoradical generator is a radical source together with the peroxydicarbonate-type organic peroxide of the component (C), generates a radical by irradiation with light, reductively decomposes the iodonium salt, generates the acid (cation: H⁺) by light, and promotes the polymerization reaction. Since the curable resin composition of the present invention contains the peroxydicarbonate-type organic peroxide of the component (C), it may not contain the photoradical generator (E). In a case where the curable resin composition contains the photoradical generator (E), the alkyl radical is produced by light to reductively decompose the iodonium salt, and the acid (cation: H⁺) is also produced by light to further promote the polymerization reaction. Examples of the photoradical generator include 1-hydroxycyclohexyl phenyl ketone (for example, Omnirad (registered trademark) 184 and the like manufactured by IGM Resins), 1-[4-(2-hydroxyethoxy)-phenyl]-2-hydroxy-2-methyl-1-propane-1-one, 2-hydroxy-1-{4-[4-(2-hydroxy-2-methyl-propionyl)-benzyl]phenyl}-2-methyl-propane-1-one, and 2-hydroxy-2-methyl-1-phenylpropane-1-one.

### (F) Filler

The filler is a component for improving fluidity, injectability, coatability, adhesiveness, and the like of the curable resin composition. When the filler is contained in the curable resin composition, a thin-film cured product having good curability and a low Tg is obtained even when the curable resin composition is cured into a thin film so as to have a thickness of, for example, 100 µm or less, preferably 50 µm or less, or even when the curable resin composition is cured by heating at a low temperature of, for example, 100°C or lower, preferably 80°C or lower. Examples of the filler include known inorganic fillers or organic fillers. The filler may be used alone or in combination of two or more kinds. The filler is preferably a powder or a particle.

Examples of the inorganic filler include calcium carbonate, magnesium carbonate, barium sulfate, magnesium sulfate, aluminum silicate, titanium oxide, alumina, zinc oxide, silicon dioxide (precipitated silica, fumed silica, and the like), kaolin, talc, glass beads, sericite activated clay, aluminum hydroxide, asbestos powder, copper oxide, copper hydroxide, iron oxide, lead oxide, magnesium oxide, tin oxide, carbon, mica, smectite, carbon black, bentonite, aluminum nitride, and silicon nitride. The filler may be added as a thixotropic agent, and the fumed silica is preferable in a case where the filler is added as the thixotropic agent. The fumed silica may be surface treated. Examples of a surface treatment agent of an inorganic thixotropic agent include monoalkyltrialkoxysilane, dimethyldichlorosilane, polydimethylsiloxane, and hexamethyldisilazane. As the surface-treated or untreated fumed silica, a commercially available product can be used. The inorganic filler is preferably silicon dioxide, glass beads, and talc from the viewpoint of adhesiveness to the adherend, and more preferably silicon dioxide from the viewpoint of improving fluidity, injectability, and coatability. Examples of the silicon dioxide include colloidal silica, hydrophobic silica (for example, Cabosil (registered trademark) TS720 and the like manufactured by Cabot Japan K.K.), spherical silica (for example, high purity synthetic spherical silica SE5200SEE and the like manufactured by Admatechs Co., Ltd.), and nanosilica. As for silicon dioxide, two or more kinds having different types or different particle sizes may be used in combination, or one kind may be used alone.

Examples of the organic filler include at least one selected from the group consisting of acrylic particles, polymethyl methacrylate, polystyrene (polystyrene beads), a copolymer obtained by copolymerizing a monomer constituting them (that is, methyl methacrylate or styrene) with another monomer, polyethylene particles, polysiloxane resin particles, polyamide particles, polyester fine particles, polyurethane fine particles, and rubber fine particles (acrylic rubber particles, isoprene rubber particles). The organic filler may have a core-shell structure. The polysiloxane resin particles may be silicone particles. From the viewpoint of adhesiveness, the organic filler is preferably the rubber fine particles, and particularly preferably the rubber fine particles having a core-shell structure. In a case where the filler is the organic filler, a weight average molecular weight of the organic filler is not particularly limited, but is preferably 50,000 to 4,000,000, and particularly preferably 300,000 to 3,000,000. As the weight average molecular weight, a value using a calibration curve by standard polystyrene can be used by gel permeation chromatography (GPC).

The average particle size of the filler is not particularly limited, but is preferably 0.01 µm or more and less than 10 µm, and particularly preferably 0.012 µm or more and 5 µm or less in order to improve fluidity, injectability, coatability, adhesiveness, and the like. The average particle size of the filler can be measured by a laser diffraction type particle size distribution measuring apparatus, a dynamic light scattering type Nanotrac particle size distribution analyzer, or the like. The average particle size may be a 50% cumulative particle size in a volume-based particle size distribution or a 50% cumulative particle size in a number-based particle size distribution.

### (G) Coupling agent

The coupling agent has two or more different functional groups in the molecule, one of which is a functional group chemically bonded to an inorganic material, and the other is a functional group chemically bonded to an organic material. When the curable resin composition contains the coupling agent, the adhesiveness of the curable resin composition can be improved in a case where different types of materials such as a camera module and a sensor module are bonded.

Examples of the coupling agent include a silane coupling agent, an aluminum coupling agent, and a titanium coupling agent, but are not limited thereto. The coupling agent may be used alone or in combination of two or more kinds.

Examples of a functional group of the silane coupling agent include a vinyl group, an epoxy group, a styryl group, a methacrylic group, an acrylic group, an amino group, an isocyanurate group, a ureido group, a mercapto group, a sulfide group, and an isocyanate group. Examples of the silane coupling agent include: silane compounds having an epoxy group and an alkoxy group, and optionally having an alkyl group, such as 2-(3,4-epoxycyclohexyl)ethyltrimethoxysilane 3-glycidoxypropyltrimethoxysilane, 3-glycidoxypropylmethyldiethoxysilane, 3-glycidoxypropyltriethoxysilane; silane compounds having an alkenyl group and an alkoxy group and optionally having an alkyl group, such as vinyltrimethoxysilane and p-styryltrimethoxysilane; silane compounds having a (meth)acrylic group and an alkoxy group and may have an alkyl group, such as 3-methacryloxypropylmethyldimethoxysilane, 3-methacryloxypropyltrimethoxysilane, 3-methacryloxypropylmethyldiethoxysilane, 3-methacryloxypropyltriethoxysilane, and 3-acryloxypropyltrimethoxysilane; silane compounds having a primary or secondary amino group and an alkoxy group, and optionally having an alkyl group, such as N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; and silane compounds having one or more groups selected from the group consisting of a mercapto group, an isocyanato group, a ureido group, and a halogen atom, and one or more alkoxy groups, and optionally having an alkyl group, such as 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, and 3-isocyanatopropyltriethoxysilane.

### (H): Ion trapping agent

The ion trapping agent traps free iodonium ions and improves various kinds of reliability of the cured product. The ion trapping agent is not particularly limited, and can be selected from those generally used as materials such as a sealing material. Specific examples thereof include hydrotalcites, and hydrated oxides of elements such as magnesium, aluminum, titanium, zirconium, and bismuth. Examples of commercially available products include IXEPLAS-A1 and IXEPLAS-A2 manufactured by Toagosei Co., Ltd. The ion trapping agent may be used alone or in combination of two or more kinds.

### (I) Colorant

The colorant can be used for the purpose of coloring the curable resin composition. As the colorant, for example, a pigment, a dye, a coloring matter, or the like can be used. As the colorant, known colorants such as red, blue, green, yellow, black, and white can be used, and examples of the black colorant include carbon black-based, graphite-based, iron oxide-based, titanium black, anthraquinone-based, cobalt oxide-based, copper oxide-based, manganese-based, antimony oxide-based, nickel oxide-based, perylene-based, aniline-based, molybdenum sulfide, and bismuth sulfide. Examples of the pigment as a commercially available product include titanium blacks 13M, 13M-C, and 13M-T manufactured by Mitsubishi Materials Electronic Chemicals Co., Ltd.

Examples of the optional component include, in addition to the coupling agent (G), the ion trapping agent (H), or the colorant (I), an additive, a leveling agent, an antioxidant, an antifoaming agent, a thixotropic agent, a viscosity modifier, a flame retardant, a colorant, a solvent, and the like.

The component (A) in the curable resin composition is preferably 90 mass% or more, may be 91 mass% or more, or may be 92 mass% or more based on 100 mass% of the total amount of the component (A), the component (B), and the component (C) in order to obtain the cured product having a low Tg by curing the component (A) by heating at a low temperature of, for example, 100°C or lower, preferably 80°C or lower. The total amount of the component (B) and the component (C) is preferably 10 mass% or less, may be 9 mass% or less, may be 8 mass% or less, and is preferably 1 mass% or more, may be 2 mass% or more, or may be 3 mass% or more based on the total amount of the component (A), the component (B), and the component (C).

In order to obtain the cured product having a low Tg by curing the curable resin composition by heating at a low temperature of, for example, 100°C or lower, preferably 80°C or lower, the total amount of the component (A), the component (B), and the component (C) is preferably 50 to 100 mass%, more preferably 55 to 95 mass%, and still more preferably 60 to 90 mass% based on 100 mass% of the total amount of the curable resin composition.

In a case where at least one selected from the group consisting of the epoxy resin having a ring skeleton in the molecule as the component (A1) and the oxetane resin as the component (A2) is contained as the cationically curable resin as the component (A) in the curable resin composition, the total amount of the component (A1) and the component (A2) is preferably 20 to 100 mass%, more preferably 30 to 90 mass%, and still more preferably 30 to 70 mass% when the total amount of the component (A) is 100 mass%. In order to obtain a cured product having a low elastic modulus, when the total amount of component (A) is 100 mass%, the component (A) may all be at least one component selected from the group consisting of the component (A1) and the component (A2), or the total amount of the component (A1) and the component (A2) may be100 mass%. In a case where the total amount of the component (A1) and the component (A2) is less than 100 mass% in the component (A), the remainder excluding the component (A1) and the component (A2) may be at least one selected from the group consisting of an epoxy resin having no ring skeleton in the molecule (for example, an aliphatic epoxy resin), a polystyrene-based compound, and a vinyl ether compound.

In a case where the component (A) in the curable resin composition contains the epoxy resin and the epoxy resin contains the epoxy resin having an aromatic ring skeleton as the component (A1), in order to obtain a thin-film cured product having a low Tg, a low elastic modulus, and a thickness of, for example, 100 µm or less by curing the curable resin composition by heating at a low temperature of, for example, 100°C or lower, preferably 80°C or lower, the epoxy resin having an aromatic ring skeleton in the component (A) is preferably 20 to 100 mass%, more preferably 15 to 95 mass%, and still more preferably 20 to 95 mass% when the total amount of the component (A) is 100 mass%.

In a case where the component (A) in the curable resin composition contains the epoxy resin, and the epoxy resin contains an epoxy resin having an aromatic ring skeleton and an epoxy group equivalent of 200 g/eq or less as the component (A1), in order to obtain a cured product having a low Tg and a low elastic modulus by curing the curable resin composition by heating at a low temperature of, for example, 100°C or lower, preferably 80°C or lower, a ratio 1 of the number of epoxy group equivalents of the component (A1) to the number of functional group equivalents in the component (A) (functional group equivalent ratio 1 = [number of epoxy group equivalents of component (A1) having an epoxy group equivalent of 200 g/eq or less]/[number of functional group equivalents of component (A)]) is preferably 0.001 to 0.8, more preferably 0.01 to 0.6, and still more preferably 0.05 to 0.4. The number of functional group equivalents in the component (A) refers to a total number of functional group equivalents contained in the component (A), and in a case where the component (A) contains, for example, both the epoxy resin and the oxetane resin, the number of functional group equivalents refers to a total number of epoxy group equivalents and oxetane group equivalents.

In a case where the component (A) in the curable resin composition contains the epoxy resin, and the epoxy resin contains an epoxy resin having an aromatic ring skeleton and an epoxy group equivalent of more than 200 g/eq as the component (A1), in order to obtain a cured product having a low Tg and a low elastic modulus by curing the curable resin composition by heating at a low temperature of, for example, 100°C or lower, preferably 80°C or lower, a ratio 2 of the number of epoxy group equivalents of the component (A1) to the number of functional group equivalents of the component (A) (functional group equivalent ratio 2 = [number of epoxy group equivalents of component (A1) having an epoxy group equivalent of more than 200 g/eq]/[number of functional group equivalents of component (A)]) is preferably 0.01 to 1.0, more preferably 0.1 to 0.9, and still more preferably 0.2 to 0.8.

In a case where the component (A) in the curable resin composition contains the epoxy resin, in order to obtain a cured product having a low Tg and a low elastic modulus by curing the curable resin composition by heating at a low temperature of, for example, 100°C or lower, preferably 80°C or lower, the epoxy resin having an alicyclic skeleton in the component (A) is preferably 0 to 50 mass%, more preferably 0 to 40 mass%, and still more preferably 1 to 30 mass% when the total amount of the component (A) is 100 mass%.

In a case where the component (A) in the curable resin composition contains the epoxy resin and the epoxy resin contains an epoxy resin having an alicyclic skeleton as the component (A1), in order to obtain a cured product having a low Tg and a low elastic modulus by curing the curable resin composition by heating at a low temperature of, for example, 100°C or lower, preferably 80°C or lower, a ratio 3 of the number of epoxy group equivalents of the epoxy resin having an alicyclic skeleton as the component (A1) to the number of functional group equivalents as the component (A) (functional group equivalent ratio 3 = [number of epoxy group equivalents of component (A1) having an alicyclic skeleton]/[number of functional group equivalents of component (A)]) is preferably 0.001 to 0.5, more preferably 0.01 to 0.5, and still more preferably 0.05 to 0.3.

The component (A) in the curable resin composition contains the epoxy resin, and the epoxy resin having an alicyclic skeleton in the component (A) may be 0 to 70 mass% or 0 to 60 mass% when the total amount of the component (A) is 100 mass%.

In a case where the component (A) in the curable resin composition contains the epoxy resin and contains an aliphatic cyclic epoxy resin of the component (A1), in order to obtain a cured product having a low Tg by curing the curable resin composition by heating at a low temperature of, for example, 100°C or lower, preferably 80°C or lower, a ratio 4 of the number of epoxy group equivalents of the component (A1) that is an aliphatic cyclic epoxy resin to the number of functional group equivalents as the component (A) (functional group equivalent ratio 4 = [number of epoxy group equivalents of component (A1) that is aliphatic cyclic epoxy resin]/[number of functional group equivalents of component (A)]) is preferably 0.01 to 0.8, more preferably 0.1 to 0.6, and still more preferably 0.1 to 0.4.

In the component (A) in the curable resin composition, the oxetane resin of the component (A2) is preferably 0 to 40 mass%, more preferably 0 to 30 mass%, and still more preferably 0 to 20 mass% when the total amount of the component (A) is 100 mass%. In a case where the oxetane resin of the component (A2) is contained in the component (A), in order to accelerate a curing rate and efficiently obtain a cured product having a low Tg by curing the curable resin composition by heating at a low temperature of, for example, 100°C or lower, preferably 80°C or lower, the content of the oxetane resin of the component (A2) is preferably 1 to 40 mass%, more preferably 2 to 30 mass%, and still more preferably 3 to 20 mass% when the total amount of the component (A) is 100 mass%.

In a case where the component (A) in the curable resin composition contains the oxetane resin of the component (A2), in order to obtain the cured product having a low Tg by curing the curable resin composition by heating at a low temperature of, for example, 100°C or lower, preferably 80°C or lower, a ratio 5 of the number of oxetane group equivalents of the oxetane resin of the component (A2) to the number of functional group equivalents of the component (A) (functional group equivalent ratio 5 = [number of oxetane group equivalents of component (A2)]/[number of functional group equivalents of component (A)]) is preferably 0.01 to 0.5, more preferably 0.05 to 0.4, and still more preferably 0.1 to 0.3.

A blending ratio of the component (A1) to the component (A2) in the component (A) in the curable resin (component (A1):component (A2)) is preferably 100:0 to 60:40, more preferably 99:1 to 70:30, and still more preferably 98:2 to 80:20 in mass ratio. When the blending ratio of the component (A1) to the component (A2) in the component (A) is 100:0 to 60:40, the curable resin composition is cured by heating at a low temperature of, for example, 100°C or lower, preferably 80°C or lower to obtain the cured product having a low Tg.

In order to cure the curable resin composition by heating at a low temperature of, for example, 100°C or lower, preferably 80°C or lower, the component (B) in the curable resin is preferably 0.1 to 10.0 parts by mass, more preferably 0.5 to 8 parts by mass, and still more preferably 1.0 to 5 parts by mass based on 100 parts by mass of the component (A).

In order to cure the curable resin composition by heating at a low temperature of, for example, 100°C or lower, preferably 80°C or lower, the component (C) in the curable resin is preferably 0.1 to 10.0 parts by mass, more preferably 0.5 to 8 parts by mass, and still more preferably 1.0 to 5 parts by mass based on 100 parts by mass of the component (A).

A blending ratio of the component (B) to the component (C) in the curable resin (component (B):component (C)) is preferably about the same, and may be 25:75 to 75:25, 30:70 to 70:30, 40:60 to 60:40, or 50:50 in mass ratio.

The photosensitizer of the component (D) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The photoradical generator of the component (E) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The filler of the component (F) in the curable resin composition may be 0 to 50 mass%, 1 to 45 mass%, or 3 to 40 mass% based on 100 mass% of the total amount of the curable resin composition. In order to obtain the thin-film cured product of, for example, 100 µm or less, preferably 50 µm or less, and in order to obtain the cured product having a low Tg by curing the curable resin composition by heating at a low temperature of, for example, 100°C or lower, preferably 80°C or lower, the filler of the component (F) in the curable resin composition is preferably 1 to 45 mass%, and more preferably 3 to 40 mass% based on 100 mass% of the total amount of the curable resin composition.

The above-mentioned optional component in the curable resin composition is 10 mass% or less, may be 0 to 10 mass%, 0.1 to 5 mass%, or 0.3~3 mass% based on 100 mass% of the total amount of the curable resin composition. As described above, at least one selected from the group consisting of the coupling agent (G), the ion trapping agent (H), and the colorant (I) may be contained as the optional component.

### Method for producing curable resin composition

The curable resin composition can be produced by mixing the component (A), the component (B), and the component (C). The curable resin composition can be produced by further mixing the component (D), the component (E), the component (F), the component (G), the component (H), the component (I), and other optional components as necessary. The curable resin composition may be produced by mixing the components together with the additive as necessary. The components can be simultaneously or separately introduced into an appropriate mixer, and stirred and mixed while being melted by heating, if necessary, to obtain the curable resin composition. A method for producing the curable resin composition is not particularly limited. The curable resin composition can be produced by mixing raw materials to be the components with the mixer such as a mortar machine, a Henschel mixer, a roll mill, a three-roll mill, a ball mill, a planetary mixer, or a bead mill equipped with a stirring device and a heating device. In addition, the curable resin composition may be produced by appropriately combining two or more devices.

The curable resin composition is preferably liquid or paste at room temperature, for example, 20°C to 30°C. A viscosity of the curable resin composition is preferably 200 Pa·s or less, or may be 190 Pa·s or less, and is preferably 1 Pa·s or more, when measured immediately after preparing the resin composition (for example, within 30 minutes) and after the resin composition is left standing at room temperature, for example, 20°C to 30°C for a predetermined time using a Brookfield rotational viscometer (HBDV-I type or RVDV-I type, spindle: SC4-14 spindle, rotation speed: 50rpm, measurement temperature: 25°C). The viscosity of the curable resin composition at 20°C to 30°C measured by the above-described method may be 3 Pa·s to 10 Pa·s.

### Adhesive or sealing material

The curable resin composition can be used as the adhesive or the sealing material for fixing, bonding, or protecting components constituting the electronic device, the camera module, or the sensor module, and can also be used as the adhesive or the sealing material containing the curable resin composition.

### Method for supplying curable resin composition

The curable resin composition can be supplied using a jet dispenser, an air dispenser, or the like. In addition, it can be supplied by a known coating method (dip coating, spray coating, bar coater coating, gravure coating, reverse gravure coating, spin coater coating, and the like) and a known printing method (plate printing, carton printing, metal printing, offset printing, screen printing, gravure printing, flexographic printing, inkjet printing, and the like).

### Curing conditions of curable resin composition

The resin composition is thermosetting, and can be cured by heating at 100°C or lower, preferably 80°C or lower, more preferably 75°C or lower, still more preferably 70°C or lower, preferably 45°C or higher, more preferably 55°C or higher, and still more preferably 60°C or higher. A heating time for curing the curable resin composition is preferably 15 minutes or more and 4 hours or less, more preferably 30 minutes or more and 2 hours or less, and still more preferably 30 minutes or more and 60 minutes or less. The curable resin composition can be heated using a blower dryer or a hot plate.

### Cured product

The cured product is obtained by curing the curable resin composition, or the adhesive or the sealing material containing the curable resin composition. The cured product obtained by curing the curable resin composition at 80°C for 60 minutes has a glass transition temperature (Tg) of preferably 0°C to 100°C, more preferably 1°C to 90°C, still more preferably 2°C to 80°C, yet still more preferably 3°C to 70°C, and particularly preferably 5 to 60°C, measured using a dynamic viscoelasticity measuring device (for example, DMA7100 or the like manufactured by Hitachi High-Tech Science Corporation). Even if the Tg of the obtained cured product is 100°C or lower, the curing can be performed at a low temperature, and the thin-film cured product having a thickness of 100 µm or less is obtained. The glass transition temperature can be measured with reference to a method in Examples described later.

A storage modulus (E') of the cured product obtained by curing the curable resin composition at 80°C for 60 minutes is preferably 5 GPa or less, may be 4.5 GPa or less, preferably 0.01 GPa or more, and more preferably 0.02 GPa or more, measured using a dynamic viscoelasticity measuring device (for example, DMA7100 or the like manufactured by Hitachi High-Tech Science Corporation). The cured product is softer as a value of the storage modulus (E') is smaller, and has followability following the expansion and contraction of the adherend which varies depending on a linear expansion coefficient of the adherend even when adherends of different types of materials are bonded.

### Semiconductor device and electronic device

As for the curable resin composition, in a case where the adhesive or the sealing material containing the curable resin composition is used for fixing, bonding, or protecting an electronic component, an electronic device containing the cured product obtained by curing the curable resin composition, or the adhesive or the sealing material containing the curable resin composition can be obtained. The electronic device may be a semiconductor device including a semiconductor element. Examples of the electronic device include a mobile phone, a smartphone, a notebook computer, a tablet terminal, and a camera module. The curable resin composition, or the adhesive or the sealing material containing the curable resin composition can be used for fixing, bonding, or protecting the electronic component, and it is possible to provide a highly reliable electronic device having a low Tg capable of being cured by heating at a low temperature of, for example, 100°C or lower, preferably 80°C or lower, and having a low storage modulus and excellent followability.

### EXAMPLES

Hereinafter, the present invention will be described by way of Examples. The present invention is not limited to these Examples.

The components used in the curable resin compositions of Examples and Comparative Examples are shown below.

### Component (A): Cationically curable resin

### Component (A1): Epoxy resin having a ring skeleton in the molecule

(A1-1): AER9000 (manufactured by Asahi Kasei Corporation), the special epoxy resin containing the compound, in which the polyalkylene oxide structure is added to the epoxy resin and the bisphenol A skeleton, molecular weight is 760, epoxy group equivalent is 380 g/eq
(A1-2): EPICLON (registered trademark) EXA-850CRP (manufactured by DIC Corporation), the bisphenol A type epoxy resin, molecular weight is 344, epoxy group equivalent is 172 g/eq
(A1-3): ADEKA GLYCILOL (registered trademark) ED-509S (manufactured by ADEKA Corporation), p-tert-butyl phenyl glycidyl ether, molecular weight is 206, epoxy group equivalent is 206/eq
(A1-4): jER YX8000 (manufactured by Mitsubishi Chemical Corporation), hydrogenated bisphenol A diglycidyl ether, molecular weight is 410, epoxy group equivalent is 205 g/eq
(A1-5): CELLOXIDE (registered trademark) 2021P (manufactured by Daicel Corporation), 3',4'-epoxycyclomethyl-3,4-epoxycyclohexanecarboxylate, molecular weight is 260, epoxy group equivalent is 130 g/eq

### Component (A): Cationically curable resin

### Component (A2): Oxetane resin

(A2-1): OXT-221 (manufactured by Toagosei Co., Ltd.), 3-ethyl-3-{[(3-ethyloxetane-3-yl)methoxy]methyl}oxetane, molecular weight is 214, oxetane group equivalent is 107 g/eq
(A2-2): OXT-101 (manufactured by Toagosei Co., Ltd.), 3-ethyl-3-hydroxymethyloxetane (oxetane alcohol), molecular weight is 116, oxetane group equivalent is 116 g/eq

### Component (B): Acid generator containing iodonium salt

(B-1): Bluesil (registered trademark) PI2074 (manufactured by ELKEM SILICONES), 4-isopropyl-4'-methyldiphenyliodonium tetrakis(pentafluorophenyl)borate
(B-2): IK-1FG (manufactured by San-Apro Ltd.)

### Component (C): peroxydicarbonate-type organic peroxide

(C-1): Perkadox 24L (manufactured by Nouryon), dicetyl peroxydicarbonate, one-hour half-life temperature is 65°C, molecular weight is 570.9, SADT is 40°C, solid (powder) at normal temperature (about 20°C to about 25°C)
(C-2): PEROYL TCP (manufactured by NOF CORPORATION), di(4-tert-butylcyclohexyl) peroxydicarbonate, one-hour half-life temperature is 58°C, molecular weight is 398.5, SADT is 45°C, solid (powder) at normal temperature (about 20°C to 25°C)
(C-3): Lupelox 225 (manufactured by ARKEMA Yoshitomi, Ltd.), di(secondary butyl) peroxydicarbonate, one-hour half-life temperature is 69°C, molecular weight is 234.2, SADT is 16°C, liquid at normal temperature (about 20°C to about 25°C)
(C-4): ditridecyl peroxydicarbonate (manufactured by Alfa Chemistry), molecular weight is 486.72, solid (powder) at normal temperature (about 20°C to 25°C)
(C-5): distearyl peroxydicarbonate (manufactured by SAGECHEM LIMITED), molecular weight is 626.99, solid (powder) at normal temperature (about 20°C to 25°C)

### Component (C'): alkylperoxyester-type organic peroxide

(C'-1): PEROCTA O (manufactured by NOF CORPORATION), 1,1,3,3-tetramethylbutylperoxy-2-ethylhexanoate, one-hour half-life temperature is 84°C, molecular weight is 272.4, SADT is 40°C
(C'-2): Lupelox 10 (manufactured by ARKEMA Yoshitomi, Ltd.), t-butyl peroxydecanoate, one-hour half-life temperature is 66°C, molecular weight is 430.6, SADT is 27°C

Values of the one-hour half-life temperature, molecular weight, and SADT of each organic peroxide are listed as catalog values.

### (D) Photosensitizer

(D-1): DETX, 2,4-diethylthioxanthone (manufactured by Nippon Kayaku Co., Ltd.)

### (E) Photoradical generator

(E-1): Omnirad (registered trademark) 184 (manufactured by IGM Resins), 1-hydroxycyclohexyl phenyl ketone

### (F) Filler

(F-1): SE5200SEE (manufactured by Admatechs Co., Ltd.), high purity synthetic spherical silica
(F-2): Cabosil (registered trademark) TS720 (manufactured by Cabot Japan K.K.), hydrophobic silica

### (G) Coupling agent

(G-1): Silane coupling agent, S530 (manufactured by JNC Corporation), 2-(3,4-epoxycyclohexyl)ethyltrimethoxysilane

### (H): Ion trapping agent

(H-1): IXEPLAS-A1 (manufactured by Toagosei Co., Ltd.), zirconium-magnesium-based ion trapping agent
(H-2): IXEPLAS-A2 (manufactured by Toagosei Co., Ltd.), zirconium-magnesium-based ion trapping agent

### (I) Colorant

(I-1): Titanium black 13M (manufactured by Mitsubishi Materials Electronic Chemicals Co., Ltd.)

### Examples 1 to 12 and Comparative Examples 1 to 6

A curable resin composition was prepared by mixing components in amounts according to blending ratios shown in Tables 1 and 2 using a three-roll mill. In Tables 1 and 2, numbers indicating the blending ratio of the components contained in the curable resin composition represent mass% based on 100 mass% of the total amount of the curable resin composition unless otherwise specified. In Tables, each component is mainly indicated by a symbol of a product name or a trade name.

In Examples and Comparative Examples, characteristics of the curable resin composition and the cured product were measured as follows. Results are shown in Tables 1 to 3. In Tables, the symbol "-" indicates that the corresponding component is not contained in the curable resin composition. Table 3 shows Examples and Comparative Examples of curable resin compositions containing no filler. Some Examples and Comparative Examples are duplicated in Table 2 and Table 3.

### Preparation of cured product

Each of the curable resin compositions of Examples 1 to 12 and Comparative Examples 1 to 6 was heated at 80°C for 60 minutes using a blower dryer to obtain a cured product.

### Examples 13 and 14

Resin compositions of Example 13 and Example 14 are respectively produced in the same manner as in Example 1 except that the component (C-1) used in Example 1 is replaced with the components (C-4) and (C-5), respectively. The characteristics of the resin compositions of Examples 13 and 14 and the cured products obtained by curing the resin compositions are measured in the same manner as in Example 1. It is assumed that in Example 13 and Example 14, a test piece for thin-film cured product test is similarly cured up to a thinnest end of the test piece, and the partial curing failure can be suppressed.

### Shear strength

A resin composition was applied onto a lower substrate (smoothing plate of liquid crystal polymer (LCP): length 74 mm, width 20 mm, thickness 2 mm) in a size of φ2 mm and a thickness of 125 µm by stencil printing, an alumina chip of 3.2 mm×1.6 mm×0.45 mm in thickness was laminated on the applied resin composition, and the resin composition was cured in a state of lightly applying a load to prepare a test piece. Curing conditions at this time were 80°C and 60 minutes in a blower dryer. Shear strength of the obtained test piece was measured at 23°C using a universal bond tester (series 4000 manufactured by Nordson Advanced Technology Inc.). Specifically, stress (unit: N) was measured at a test speed of 200 µm/s using the universal bond tester. The shear strength when the liquid crystal polymer (LCP) was used as the lower substrate and an upper substrate was taken as LCP shear strength. This measurement was performed on 10 test pieces, and an average value of the obtained stresses was calculated. This average value was taken as the shear strength (unit: N) of the cured product. Further, as the lower substrate and the upper substrate, the shear strength when polyphthalamide (PPA) was used as a lower substrate having the same size as the liquid crystal polymer instead of the liquid crystal polymer (LCP) was taken as a PPA shear strength.

### Curability at 80°C

First, a Teflon (registered trademark) sheet was attached to a surface of a glass plate having a thickness of 3 mm, and spacers (obtained by stacking heat-resistant tapes) were arranged at two locations thereon so that a film thickness when cured was 400±150 µm. Next, the curable resin composition was applied between the spacers, and the glass plate was sandwiched between other glass plates having a Teflon (registered trademark) sheet attached to a surface thereof so as not to catch bubbles, and was cured by heating at 80°C for 60 minutes using a blower dryer. By sandwiching with the glass plates, the curability can be determined without considering influence of the inhibition by oxygen. When the curable resin composition was cured and had no tackiness, it was rated as good (Good, "G"), when the curable resin composition was cured but had tackiness, it was rated as insufficient (Poor, "P"), and when the curable resin composition was liquid and was not cured, it was rated as not good (Bad, "B"). The tackiness was observed by finger touch.

### Cured length and cured film thickness of test piece for thin-film cured product test

Fig. 1 illustrates a method for producing the test piece for thin-film cured product test of the curable resin composition. As illustrated in Fig. 1, a tape 2 having a thickness of 50 µm was disposed at a distance of 10 mm in width from an end 1a of a substrate 1 to form a step of a thickness of the tape 2. The tape 2 was adhered to the substrate 1 so as not to move. As the substrate 1, a substrate made of liquid crystal polymer (LCP) and having a thickness of 2 mm, a width of 20 mm, and a length of 74 mm was used. The tape 2 was made of polyimide. A squeegee was moved from the tape 2 toward the end 1a of the substrate 1 to apply the curable resin composition in a fillet shape in which an end surface of the curable resin composition was substantially triangular, to prepare a coated product. The prepared coated product was heated at 80°C for 60 minutes using a blower dryer to prepare a test piece 3 for thin-film cured product test having a substantially triangular end surface. After heating at 80°C for 60 minutes, the prepared test piece 3 was visually observed, and a cured length of the test piece 3 in a direction from the tape 2 to the end 1a of the substrate 1 was measured and taken as the cured length (mm) of the test piece. As the thickness of the test piece 3 is thinner, progress of the polymerization reaction in the curable resin composition is slower, and the curable resin composition is less likely to be cured. In the thin-film test piece 3, a portion that is cured and a portion that is not cured can be visually observed.

Since the test piece 3 for thin-film cured product test has an end surface of substantially triangular shape, from the cured length of the test piece 3 in a direction from a side of the tape 2 having a largest thickness of the test piece 3 to a side of the end 1a of the substrate 1 having a smallest thickness of the test piece 3, it was measured as a thinnest thickness cured film thickness in the cured portion using the following conversion formula. Cured film thickness (µm) = 5 × (maximum cured length of test piece 10 mm - cured length of test piece (mm))

In Tables 1 and 2, in the above conversion formula, when the cured film thickness is 0 µm, it is considered that the cured film has been cured up to the end, and is described as A. Numerical values are the cured film thickness (µm) measured in the conversion formula. Those not cured were described as F.

### Storage modulus (E') and glass transition temperature (Tg) of cured product

Measurement was performed according to Japanese Industrial Standard JIS C6481. Specifically, first, the Teflon (registered trademark) sheet was attached to the surface of the glass plate having a thickness of 3 mm, and the spacers (obtained by stacking heat-resistant tapes) were arranged at two locations thereon so that the film thickness when cured was 400±150 µm. Next, the curable resin composition was applied between the spacers, and the glass plate was sandwiched between other glass plates having a Teflon (registered trademark) sheet attached to the surface so as not to catch bubbles, and heated at 80°C for 60 minutes using a blower dryer to obtain a cured product obtained by curing the curable resin composition. Finally, the cured product was peeled off from the glass plate to which the Teflon (registered trademark) sheet was attached, and then cut into a predetermined size (length: 10 mm, width: 40 mm) with a cutter to obtain a test piece. Note that a cut was smoothed with sandpaper. An initial Tg of the cured product was measured by a tensile method using a dynamic viscoelasticity measuring device (DMA) (manufactured by Hitachi High-Tech Science Corporation) in a range of -20°C to 200°C, a frequency of 10 Hz, a heating rate of 3°C/min, a strain amplitude of 5 µm. The Tg was determined by measuring storage modulus (E') and loss modulus (E") of the cured product, and determining a peak temperature of dielectric tangent (tan δ) calculated from E"/E' as Tg.

**[Table 1]**

| | | | | Example 1 | Example 2 | Example 3 | Example 4 | Example 5 | Example 6 | Example 7 | Example 8 |
|---|---|---|---|---|---|---|---|---|---|---|---|
| (A) | (A1) | (A1-1) | AER9000 | 11.71 | 28.02 | 29.95 | 23.57 | 35.54 | 22.43 | 44.93 | 54.21 |
| | | (A1-2) | EXA-850CRP | - | - | - | - | - | - | - | - |
| | | (A1-3) | ED-509S | - | 7.59 | - | - | - | 6.08 | - | - |
| | | (A1-4) | YX8000 | 37.9 | 45.34 | 26.93 | 25.44 | 23.96 | 18.15 | 4.85 | 1.83 |
| | | (A1-5) | 2021P | - | - | - | 4.03 | - | 15.35 | - | - |
| | (A2) | (A2-1) | OXT-221 | 9.89 | 3.94 | 5.62 | 9.96 | 2.5 | - | 10.12 | 2.86 |
| | | (A2-2) | OXT-101 | - | - | - | - | - | - | - | - |
| (B) | (B-1) | | PI2074 | 3 | 2 | - | 1 | 1 | 1 | 2 | 2 |
| | (B-2) | | IK-1FG | - | - | 2 | - | - | - | - | - |
| (C) | (C-1) | | Perkadox24L | 1 | 1 | - | - | 1 | - | - | 1 |
| | (C-2) | | PEROYL TCP | - | - | 1 | - | - | 2 | 3 | 2 |
| | (C-3) | | Lupelox 225 | - | - | - | 1 | - | - | - | - |
| (C') | (C'-1) | | PEROCTA O | - | - | - | - | - | - | - | - |
| | (C'-2) | | Lupelox 10 | - | - | - | - | - | - | - | - |
| (D) | (D-1) | | DETX | - | 0.1 | 0.1 | 0.1 | 0.1 | 0.1 | 0.1 | 0.1 |
| (E) | (E-1) | | Omniradl84 | 1 | - | - | - | - | - | - | - |
| (F) | (F-1) | | SE5200SEE | 30 | | 30 | 30 | 30 | 30 | 30 | 30 |
| | (F-2) | | TS720 | 3 | 10 | 3 | 3 | 3 | 3 | 3 | 3 |
| (G) | (G-1) | | S530 | 2.5 | 2 | | 0.5 | 1.5 | 0.5 | 1 | 2 |
| (H) | (H-1) | | IXEPLAS-A1 | - | - | 1 | 1 | 1 | 1 | 1 | 1 |
| | (H-2) | | IXEPLAS-A2 | - | - | - | - | - | - | - | - |
| (I) | (I-1) | | Titan Black 13M | - | - | 0.4 | 0.4 | 0.4 | 0.4 | - | - |
| LCP shear strength (N) | | | | 136 | 132 | 134 | 122 | 91 | 136 | 47 | 28 |
| PPA shear strength (N) | | | | 236 | 130 | 148 | 158 | 96 | 214 | 59 | 35 |
| Curability at 80°C | | | | G | G | G | G | G | G | G | G |
| Thin-film cured product test | | Cured length (mm) | | 10 | 10 | 10 | 6 | 10 | 10 | 10 | 10 |
| | | Cured film thickness (µm) | | A | A | A | 20 | A | A | A | A |
| Glass transition temperature Tg (°C) | | | | 92 | 64 | 59 | 76 | 41 | 84 | 25 | 12 |
| Storage modulus E' (GPa) | | | | 4.5 | 3.5 | 4.3 | 4.1 | 2.4 | 4.2 | 0.2 | 0.02 |

**[Table 2]**

| | | | | Example 9 | Example 10 | Example 11 | Comparative Example 1 | Comparative Example 2 | Comparative Example 3 | Comparative Example 4 | Comparative Example 5 |
|---|---|---|---|---|---|---|---|---|---|---|---|
| (A) | (A1) | (A1-1) | AER9000 | 59.9 | - | 31.32 | 58.39 | - | 28.7 | 22.43 | 31.32 |
| | | (A1-2) | EXA-850CRP | - | - | - | - | 30.75 | - | - | - |
| | | (A1-3) | ED-509S | - | - | 5.66 | - | 30.75 | - | 6.08 | 5.66 |
| | | (A1-4) | YX8000 | - | 59.9 | 11.26 | - | - | 25.81 | 18.15 | 11.26 |
| | | (A1-5) | 2021P | - | - | - | - | - | - | 15.35 | - |
| | (A2) | (A2-1) | OXT-221 | - | - | - | 4.11 | - | 5.39 | - | - |
| | | (A2-2) | OXT-101 | - | - | 11.76 | - | - | - | - | 11.76 |
| (B) | (B-1) | | PI2074 | 2 | 2 | 2 | 1 | 3 | 2 | 1 | 2 |
| | (B-2) | | IK-1FG | - | - | - | - | - | - | - | - |
| (c) | (C-1) | | Perkadox24L | - | - | 2 | - | - | - | - | - |
| | (C-2) | | PEROYL TCP | 2 | 2 | - | - | - | - | - | - |
| | (C-3) | | Lupelox 225 | - | - | - | - | - | - | - | - |
| (C') | (C'-1) | | PEROCTA O | - | - | - | - | 1 | - | - | - |
| | (C'-2) | | Lupelox 10 | - | - | - | 1 | - | 2 | 2 | 2 |
| (D) | (D-1) | | DETX | 0.1 | 0.1 | - | - | - | 0.1 | 0.1 | - |
| (E) | (E-1) | | Omnirad184 | - | - | - | 1 | 1 | 1 | - | - |
| (F) | (F-1) | | SE5200SEE | 30 | 30 | 30 | 30 | 30 | 30 | 30 | 30 |
| | (F-2) | | TS720 | 3 | 3 | 3 | 3 | 3 | 3 | 3 | 3 |
| (G) | (G-1) | | S530 | 1 | 1 | 3 | 1.5 | 0.5 | 1 | 0.5 | 3 |
| (H) | (H-1) | | IXEPLAS-A1 | - | - | - | - | - | 1 | 1 | - |
| | (H-2) | | IXEPLAS-A2 | 2 | 2 | - | - | - | - | - | - |
| (I) | (I-1) | | Titan Black 13M | - | - | - | - | - | - | 0.4 | - |
| LCP shear strength (N) | | | | 35 | 156 | 59 | 0 | 0 | 114 | 112 | 55 |
| PPA shear strength (N) | | | | 16 | 264 | 41 | 0 | 0 | 102 | 117 | 43 |
| Curability at 80°C | | | | G | G | G | P | G | G | G | G |
| Thin-film cured product test | | Cured length (mm) | | 10 | 10 | 10 | 0 | 0 | 4 | 0 | 0 |
| | | Cured film thickness (µm) | | A | A | A | F | F | 30 | F | F |
| Glass transition temperature Tg (°C) | | | | 10 | 117 | 28 | 10 | 90 | 43 | 76 | 25 |
| Storage modulus E' (GPa) | | | | 0.02 | 5.0 | 0.4 | 0.02 | 5.3 | 2.4 | 5.0 | 0.2 |

**[Table 3]**

| | | | | Example 11 | Example 12 | Comparative Example 5 | Comparative Example 6 |
|---|---|---|---|---|---|---|---|
| (A) | (A1) | (A1-1) | AER9000 | 31.32 | 48.54 | 31.32 | 46.24 |
| | | (A1-2) | EXA-850CRP | - | - | - | - |
| | | (A1-3) | ED-509S | 5.66 | 8.77 | 5.66 | - |
| | | (A1-4) | YX8000 | 11.26 | 17.46 | 11.26 | 41.58 |
| | | (A1-5) | 2021P | - | - | - | - |
| | (A2) | (A2-1) | OXT-221 | - | - | - | 8.68 |
| | | (A2-2) | OXT-101 | 11.76 | 18.23 | 11.76 | - |
| (B) | (B-1) | | PI2074 | 2 | 2 | 2 | 1 |
| | (B-2) | | IK-1FG | - | - | - | - |
| (C) | (C-1) | | Perkadox24L | 2 | 2 | | |
| | (C-2) | | PEROYL TCP | - | - | - | - |
| | (C-3) | | Lupelox 225 | - | - | - | - |
| (C') | (C'-1) | | PEROCTA O | - | - | - | 2 |
| | (C'-2) | | Lupelox 10 | - | - | 2 | - |
| (D) | (D-1) | | DETX | - | - | - | - |
| (E) | (E-1) | | Omnirad184 | - | - | - | - |
| (F) | (F-1) | | SE5200SEE | 30 | - | 30 | - |
| | (F-2) | | TS720 | 3 | - | 3 | - |
| (G) | (G-1) | | S530 | 3 | 3 | 3 | 0.5 |
| (H) | (H-1) | | IXEPLAS-A1 | - | - | - | - |
| | (H-2) | | IXEPLAS-A2 | - | - | - | - |
| (I) | (I-1) | | Titan Black 13M | - | - | - | - |
| Curability at 80°C | | | | G | G | G | G |
| Thin-film cured product test | | | | G | G | B | B |
| Glass transition temperature Tg (°C) | | | | 28 | 27 | 25 | 54 |
| Storage modulus E' (GPa) | | | | 0.4 | 0.2 | 0.2 | 2.7 |

As shown in Tables 1 to 3, the cured products of the curable resin compositions of Examples 1 to 11 had higher LCP share strength and PPA share strength than the cured products of the curable resin compositions of Comparative Examples 1 and 2, and were excellent in adhesiveness to the adherend. Further, in Examples 1 to 3 and 5 to 11, the cured length of the test for thin-film cured product test was as long as 10 mm, and the test piece for thin-film cured product test having a substantially triangular end surface was cured up to the thinnest end of the test piece, and the partial curing failure was suppressed. The cured product of the curable resin composition of Example 4 had a cured length of 6 mm and a cured film thickness of 20 µm, which is considered to be because the peroxydicarbonate-type organic peroxide of the component (C-3) is liquid at normal temperature, and thus remains as low molecular weight molecules in the resin composition after being decomposed by a reaction, and curability of the resin composition is deteriorated. On the other hand, it was considered that since the peroxydicarbonate-type organic peroxide of the component (C-1) or the component (C-2) was solid at normal temperature, the peroxydicarbonate-type organic peroxide remained as a solid even after decomposition during the reaction, and did not inhibit thin film curability of the resin composition even after decomposition. As a result, the test piece was cured up to the end having a cured film thickness that was difficult to be cured. The cured product of each of the curable resin compositions of Examples 1 to 9 and 11 had a low Tg of 0°C to 100°C, the curable resin composition was cured by heating at a low temperature of 80°C or lower, and the cured product having a low Tg was obtained. The cured product of the curable resin composition of Example 10 had a slightly higher Tg of 117°C, but a cured product having a Tg of 120°C or lower was obtained. The cured products of the curable resin compositions of Examples 1 to 11 had a low storage modulus (E') of 0.02GPa to 5.0GPa, and the cured product having followability following the expansion and contraction of the adherend was obtained.

As shown in Table 3, in the curable resin composition of Example 12 and the curable resin composition of Comparative Example 3 which contain no filler (F), the coatability and the adhesiveness were deteriorated, a coated product having a triangular end surface could not be formed, and the cured film thickness could not be measured. Therefore, as another test for evaluating the thin film curability, the cured product was prepared by forming the coated product into a strip shape having a film thickness of 50 µm and a width of 5 mm. The cured product formed into a strip shape was touched to determine the presence or absence of curing. In Table 2, the results are described as thin-film cured product tests. The cured product formed into a strip shape was touched, and when the cured product was cured, the cured product was evaluated as good (Good, "G"), and when the cured product was not cured and was liquid, the cured product was evaluated as (Bad, "B"). Even when the cured product of the curable resin composition of Example 12 did not contain the filler (F), curability of a cured product of a thin film having a film thickness of 50 µm was obtained. The cured product of each of the curable resin compositions of Examples 11 and 12 had a low Tg of 0°C to 100°C, the curable resin composition was cured by heating at a low temperature of 80°C or lower, and the cured product having a low Tg was obtained. The cured products of the curable resin compositions of Examples 11 and 12 had a low storage modulus (E') of 0. 1GPa to 1.0GPa, and the cured product having followability following the expansion and contraction of the adherend was obtained.

As shown in Tables 2 and 3, in the cured products of the curable resin compositions of Comparative Examples 1 to 6 containing an organic peroxide that is not a peroxydicarbonate-type as the organic peroxide, it was presumed that the cured products of Comparative Examples 1 and 2 had low LCP share strength and PPA share strength, were affected by the inhibition by oxygen, were not sufficiently cured, and did not exhibit strength. The cured products of Comparative Examples 1, 2, 4, and 5 had a curing length of 0 mm in the test for the thin-film cured product test, and were not cured in the form of a thin film. The cured product of Comparative Example 2 had a storage modulus (E') more than 5.0 GPa, and it was presumed that the followability following the expansion and contraction of the adherend was deteriorated. The cured product of Comparative Example 6 containing no filler (F) was not cured even when formed into a strip shape.

### INDUSTRIAL APPLICABILITY

The curable resin composition according to the present invention can be suitably used as the adhesive or the sealing material for fixing, bonding, or protecting the components constituting the electronic device. The resin composition, the adhesive or the sealing material containing the resin composition, a cured product obtained by curing a die attach agent, and the electronic device containing the cured product of the embodiment of the present invention can be used for, for example, a mobile phone, a smartphone, a notebook computer, a tablet terminal, a camera module, a sensor module, and the like.

### LIST OF REFERENCE SIGNS

- 1: Substrate
- 2: Tape
- 3: Test piece

## Claims

1. A curable resin composition comprising the following components (A) to (C):
(A) a cationically curable resin;
(B) an acid generator containing an iodonium salt; and
(C) a peroxydicarbonate-type organic peroxide.

2. The curable resin composition according to claim 1, wherein the component (A) comprises at least one selected from the group consisting of:
(A1) an epoxy resin having a ring skeleton in a molecule of the epoxy resin; and
(A2) an oxetane resin.

3. The curable resin composition according to claim 2, wherein the component (A1) has an aromatic ring skeleton.

4. The curable resin composition according to any one of claims 1 to 3, wherein a one-hour half-life temperature of the component (C) is 50°C to 80°C.

5. The curable resin composition according to any one of claims 1 to 4, wherein the iodonium salt contained in the component (B) is an iodonium salt compound represented by the following Formula (1):
**Ar¹** - **I⁺ - Ar² ▪Z⁻** (1)
(in Formula (1), Ar¹ and Ar² are each independently a substituted or unsubstituted aryl group, and Z⁻ is an anion).

6. The curable resin composition according to claim 5, wherein Z⁻ in Formula (1) is BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s are the same or different from each other).

7. The curable resin composition according to claim 2 or 3, wherein the component (A1) comprises an epoxy resin having an epoxy group equivalent of 100 g/eq to 1000 g/eq.

8. An adhesive or a sealing material comprising the curable resin composition according to any one of claims 1 to 7.

9. A cured product obtained by curing the curable resin composition according to any one of claims 1 to 7, or the adhesive or the sealing material according to claim 8.

10. The cured product according to claim 9, wherein the cured product has a glass transition temperature (Tg) of 0°C to 100°C.

11. A semiconductor device comprising the cured product according to claim 9 or 10.

12. An electronic device comprising the cured product according to claim 9 or 10.
